# EUROPÄISCHE PATENTSCHRIFT

(11) **EP 2 432 610 B1**
(45) Veröffentlichungstag und Bekanntmachung des Hinweises auf die Patenterteilung: **05.11.2014**
(21) Anmeldenummer: 10730041.0
(22) Anmeldetag: 06.05.2010
(51) Int. Cl.: B22D 27/04, C30B 11/00, C30B 29/06

(54) **VORRICHTUNG ZUM GERICHTETEN ERSTARREN GESCHMOLZENER METALLE**
APPARATUS FOR THE DIRECTED SOLIDIFICATION OF MOLTEN METALS
DISPOSITIF DE SOLIDIFICATION DIRIGÉE DE MÉTAL FONDU

(30) Priorität: 22.05.2009 DE 102009022412
(43) Veröffentlichungstag der Anmeldung: 28.03.2012
(73) Patentinhaber: ALD Vacuum Technologies GmbH, 63450 Hanau (DE)
(72) Erfinder: FRANZ, Henrik, 63579 Freigericht-Horbach (DE); PFAHLS, Franz, 63628 Bad Soden-Salmünster (DE); MÜLLER, Kai, 63599 Biebergemünd (DE)
(74) Vertreter: Hebing, Norbert
(86) Internationale Anmeldenummer: PCT/DE2010/000504
(87) Internationale Veröffentlichungsnummer: WO 2010/133200

(56) Entgegenhaltungen:
- EP-A1- 0 462 494
- WO-A1-2009/014961
- US-A1- 2007 227 189

## Beschreibung

Die Erfindung bezieht sich auf eine Vorrichtung zum gerichteten Erstarren geschmolzener Metalle, aufweisend einen Tiegel, eine Heizeinrichtung und eine Kühlplatte unterhalb des Tiegelbodens.

Eine derartige Vorrichtung, die insbesondere der Herstellung von Siliziumblöcken dient, die wiederum u. a. zur Herstellung von Solarzellen benötigt werden, ist in der DE 198 31 388 A1 beschrieben. In dem Tiegel wird mittels der Heizeinrichtung aus in dem Tiegel z. B. in Form von Granulat eingebrachtem Silizium zunächst eine Siliziumschmelze erzeugt, die danach in definierter Weise abgekühlt wird, indem die Wärmeenergie der Schmelze in Form von Strahlung über den Tiegelboden abgegeben wird. Dies hat zur Folge, dass die Schmelze am Tiegelboden beginnend erstarrt. Zum Abkühlen der Schmelze wird gemäß der DE 198 31 388 A1 die Kühlplatte vertikal in Richtung auf den Tiegelboden verfahren, wobei vertikal an der Kühlplatte angebrachte Wärmeleitkörper in entsprechende Ausnehmungen im Tiegelboden eintauchen. Die Wärmeleitung und damit die Kühlleistung kann somit durch Variation des Abstandes der Kühlplatte zum Tiegelbodens variiert werden.

Es ist aus der DE 199 349 40 A1 auch schon bekannt, die Kühlplatte fest anzuordnen und den Strahlungsfluss vom Tiegelboden zur Kühlplatte mit einer seitlich verschiebbaren, mehrteiligen Strahlungssperre zu steuern, die sich in einem Hohlraum oberhalb der Kühlplatte befindet. Der Strahlungsfluss zur Kühlplatte ist gering, wenn sich die Strahlungssperre im Hohlraum befindet, weil dann die Kühlplatte abgeschirmt ist, und ist erhöht, nachdem die Strahlungssperre teil

weise oder ganz horizontal aus dem Hohlraum herausgezogen wurde, weil dann die Kühlplatte weniger abgeschirmt ist bzw. zum Tiegelboden hin frei liegt.

In der US 2007/0227 189 A1 wird ein System beschrieben, bei dem ein Tiegel auf einem wärme leitenden Sockel ruht. Dieser kann zur Kühlung der Schmelze in Kontakt gebracht werden mit einem Kühlelement.

In der WO 2009/014 961 A1 wird ein System beschrieben, bei dem ein Wärme leitendes Element unterhalb des Tiegels von einem thermisch isolierenden Rahmen umgeben ist. Der Rahmen liegt in etwa im Bereich der Kante zwischen dem Boden und den Seitenwänden des Tiegels, so dass dort ein minimierter Wärmeabfluss realisiert ist.

Gemäß der EP 0 462 494 A1 wird die Kühlleistung dadurch bestimmt, in dem ein Kühlkopf näher an die Bodenplatte des Tiegels herangeführt wird. Der Raum zwischen dem Kühlkopf und der Bodenplatte bleibt frei.

Um einen sehr gleichmäßigen Kristall zu erreichen, ist es vor allem notwendig, dass die Kristallisation über den gesamten Boden des Tiegels gleichzeitig erfolgt: Entsteht nämlich schon am Tiegelboden durch Temperaturunterschiede eine Fehlstelle, so setzt sich diese unter Umständen durch den gesamten Kristall fort. Mit der Vorrichtung gemäß der DE 198 31 388 A1 kann dies nicht in zufriedenstellender Weise erreicht werden.

Die Erfindung beruht auf der Aufgabe, die Wärmeflussverteilung über den Tiegelboden weiter zu verbessern, damit beim Abkühlen der Schmelze ein möglichst fehlstellenfreier Kristall entsteht.

Zur Lösung der Aufgabe wird erfindungsgemäß vorgeschlagen, dass eine entfernbare Strahlungssperre zwischen dem Tiegelboden und der Kühlplatte angeordnet ist, dass die Strahlungssperre aus wenigstens zwei übereinander angeordneten Isolationsplatten besteht, die einen Stapel bilden und die unabhängig voneinander entfernbar sind, und dass wenigstens eine der Isolationsplatten des Stapels wenigstens eine Ausnehmung aufweist.

Durch die Verteilung der Ausnehmungen in den Isolationsplatten lässt sich eine laterale Verteilung der Isolationswirkung erreichen, so dass sich die auf den Tiegelboden bezogene Kühlleistung über dessen Ausdehnung variieren lässt. Die Verteilung lässt sich im Lauf des Erstarrungsvorganges ändern, indem die Zahl der Isolationsplatten, die sich jeweils aktuell unter dem Tiegelboden befindet, variiert wird, indem einzelne oder alle entfernt werden. Wenn die Anordnung und Verteilung der Ausnehmungennehmungen in den Isolationsplatten unterschiedlich ist, ergibt sich eine hohe Anzahl von Variationsmöglichkeiten.

Die Zahl der Variationsmöglichkeiten ist besonders hoch, wenn nicht nur zwei, sondern wenigstens drei Isolationsplatten vorgesehen werden.

Unter einer Ausnehmung soll in erster Linie eine vollständige Durchbrechung der Isolationsplatte verstanden werden. Es kann sich aber auch um eine einen Boden aufweisende Vertiefung in der Isolationsplatte handeln.

Werden zu Beginn der Kristallisation alle Isolationsplatten gemeinsam in den Hohlraum zwischen dem Tiegelboden und der Kühlplatte geschoben, wird in den Randbereichen der Tiegelbodenfläche eine gegenüber dem Zentrum des Bodens erhöhte Wärmesperrwirkung erzielt, falls insbesondere die oberste Isolationsplatte des Stapels eine vorzugsweise zentrale Ausnehmung aufweist. Dadurch erfährt die Schmelze über die gesamte Bodenfläche eine in etwa gleiche Temperatursenkung, da in den Randbereichen ein zusätzlicher Wärmeverlust in radialer Richtung stattfindet. Dies hat zur Folge, dass die Kristallisation über die gesamte Bodenfläche des Tiegels gleichmäßig einsetzt und ein ungestörter Kristallaufbau beginnt. Grundsätzlich können aber auch mehrere Ausnehmungen in einer Isolationsplatte vorgesehen werden, deren Verteilung und Anordnung so gewählt werden, dass bevorzugte Wachstumsregionen festgelegt bzw. geschaffen werden.

Im weiteren Verlauf der Kristallisation werden die Isolationsplatten nach und nach entnommen, bis entweder keine oder nur noch eine volle Isolationsplatte in dem Hohlraum verbleibt, die keine Ausnehmung besitzt. Beim weiteren Aufbau des Kristalls ist nämlich eine Fehlstellenbildung nicht mehr zu erwarten, da eine weitere Kristallisation an einen schon fehlerfrei aufgebauten Kristallabschnittes anschließt. Eine andere Erklärung für eine fehlerfreie Kristallisation mit Hilfe der Erfindung könnte auch darin liegen, dass wegen der schnelleren Abkühlung der Schmelze im Zentrum des Tiegelbodens die Kristallisation dort beginnt und sich von dort konzentrisch nach außen fehlerfrei fortsetzt.

Um die Wärmesperrwirkung noch besser dem Kristallaufbau anpassen zu können, weisen nicht nur die oberste, sondern auch die jeweils weiter unten im Stapel liegenden Isolationsplatten Ausnehmungen auf, deren Öffnungsflächen sich sukzessive ändern. Beispielsweise werden die Öffnungsflächen der Ausnehmungen von weiter oben liegenden Isolationsplatten sukzessive größer, je höher sie im Stapel liegen. Insbesondere bei einer solchen Ausführung sind vorzugsweise wenigstens drei Isolationsplatten vorgesehen.

Da der Tiegel und die gesamte Anordnung symmetrisch aufgebaut ist, sieht die Erfindung weiterhin vor, dass die Ausnehmungen eine gemeinsame Symmetrieachse aufweisen.

Vorzugsweise besitzt die Heizeinrichtung wenigstens eine Bodenheizeinrichtung, die unterhalb des Bodens des Tiegels angeordnet ist, wobei die Strahlungssperre unterhalb der Bodenheizeinrichtung angeordnet ist. Die Bodenheizeinrichtung besteht dabei aus einzelnen Stäben, die die Wärmeabstrahlung des Tiegelbodens zur Kühlplatte nicht behindern.

Die Isolationsplatten werden wie üblich aus Graphit, Graphitfilz, Keramik oder aus einer Materialkombination der genannten Materialien hergestellt.

Wenn die Isolationsplatten unterschiedlich dick sind, steht ein weiterer Parameter zur Verfügung, um die jeweilige Wärmesperrwirkung an den Kristallisationsverlauf anzupassen.

Im Folgenden soll anhand eines Ausführungsbeispiels die Erfindung näher erläutert werden. Dazu zeigen:
- Fig. 1: eine Querschnittsdarstellung einer erfindungsgemäßen Vorrichtung mit drei Isolationsplatten und
- Fig. 2: eine Detaildarstellung eines Stapels aus Isolationsplatten in der Draufsicht (Teilfigur a) und im Querschnitt(Teilfigur b).

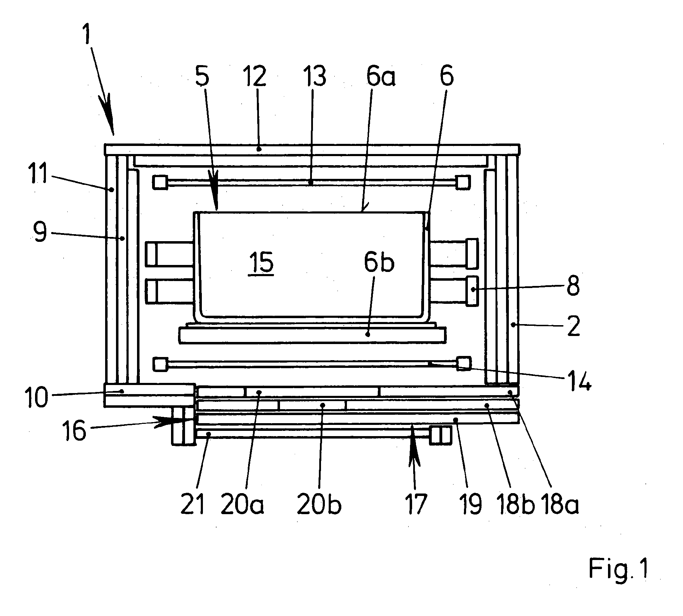

In Fig. 1 ist eine gasdichte Kristallisationskammer 1 dargestellt, die die Form eines hohlen Quaders hat. In der Kristallisationskammer 1 befindet sich eine Kristallisationseinrichtung 5, zu der ein quaderförmiger Tiegel 6 gehört, der eine obenliegende Tiegelöffnung 6a, innere Wände und einen Boden 6b aus Siliziumdioxid (Quarz) hat, der Tiegel 6 ist in einem nicht näher dargestellten topfförmigen Behälter aus Graphit angeordnet. Die Tiegelwände sind auf allen Seiten von einer Umfangsheizeinrichtung 8 umgeben. Zusätzlich befindet sich oberhalb des Tiegels eine Deckenheizeinrichtung 13.

Die Anordnung aus Tiegel 6, Umfangsheizeinrichtung 8 und Deckenheizeinrichtung 13 ist von einer strahlungsdichten Wärmedämmeinrichtung 9 umgeben, die aus einem Boden 10, Seitenwänden 11 und einem Deckel 12 besteht, unter dem die Deckenheizeinrichtung 13 angeordnet ist. Auf dem Boden 10 der Kristallisationskammer 1 und unterhalb des Tiegels 6 ruht eine Bodenheizeinrichtung 14. Durch die genannten Heizeinrichtungen 8, 13 und 14 lässt sich aus einchargiertem festem Siliziumgranulat eine Siliziumschmelze 15 erzeugen, in der nach dem Aufschmelzen eine zumindest nahezu isotherme Temperaturverteilung vorliegt.

Unterhalb der Bodenheizeinrichtung 14 befindet sich ein flacher, quaderförmiger Hohlraum 16, in den von der Seite her eine Strahlungssperre 17 einschiebbar ist. Die Strahlungssperre 17 besteht in dieser Ausführung aus drei übereinander angeordneten und einzeln seitlich verschiebbaren Isolationsplatten 18a, 18b, 19, wobei die oberen Isolationsplatten 18a, 18b jeweils eine Ausnehmung 20a, 20b aufweisen und die unterste Isolationsplatte 19 vollflächig ausgeführt ist.

Unterhalb der Strahlungssperre befindet sich eine Kühlplatte 21. Diese hat die Aufgabe, die beim Abkühlen der Schmelze vom Boden 6b des Tiegels 6 abstrahlende Wärmeenergie aufzunehmen. Durch das Einschieben der Strahlungssperre 17 wird die effektive Wärmeabstrahlung gesteuert. Bei einer eingeschobenen Strahlungssperre 17 gelangt nämlich nur ein Teil der Wärmeabstrahlung zur Kühlplatte 21 und kann dort absorbiert und abgeleitet werden. Der andere Teil der wärmeabstrahlung wird von der Strahlungssperre 17 unmittelbar reflektiert bzw. erhöht deren Temperatur, so dass Wärme in Form von Strahlung zum Tiegelboden 6b zurückgestrahlt wird. Durch Einschieben der Isolationsplatten 18a, 18b, 19 der Strahlungssperre 17, und zwar einzeln oder in Kombination, kann somit die Kühlleistung bezogen auf den Tiegelboden 6b beeinflusst werden, wobei die Kühlkapazität der Kühlplatte 21 an sich konstant gehalten wird.

Da die Isolationsplatten 18a, 18b, 19 einzeln, aber auch gemeinsam vor die Kühlplatte 21 geschoben werden können, kann auch Einfluss auf die Flächenverteilung der Strahlungssperrwirkung genommen werden.

Beim Einsetzen der Abkühlung wird die bis dahin isotherme Temperaturverteilung so verändert, dass in der Schmelze 15 eine fehlstellenfreie nahezu waagerechte Phasengrenze von unten nach oben wandert, die eine gerichtete Erstarrung der Schmelze 15 zu einem Siliziumblock ermöglicht.

Am Beginn der Kristallisation sind alle Isolationsplatten 18a, 18b, 19 eingeschoben. Es hat sich gezeigt, dass damit ein gleichmäßiger Start der Kristallisation über die gesamte Tiegelbodenfläche bzw. ein definierter Start im Zentrum der Tiegelbodenfläche erreicht werden kann.

Oberhalb des Deckels 12 und konzentrisch zu diesem ist ein Chargierbehälter befestigt. Dieser ist hier nicht näher dargestellt, kann aber z. B. so ausgeführt sein, wie dies in der DE 199 34 940 A1 beschrieben ist: Demnach hat der Chargierbehälter die Form einer flachen, auf dem Kopf stehenden 4-seitigen Pyramide, in der sich eine weitere Charge aus granulatförmigem Silizium befindet. An der Spitze dieser Pyramide befindet sich eine Chargieröffnung, die zunächst durch eine Stopfenstange verschlossen ist. Damit hat es folgende Bewandtnis: Der Deckel 12 gibt nach oben hin erhebliche Energiemengen durch Strahlung ab, die den Chargierbehälter mit seinem Inhalt aufheizen. In diesem Bereich können Temperaturen von etwa 400 °C herrschen. Dadurch wird das Granulat sehr wirksam entgast und insbesondere von Wasser und/oder Wasserdampf befreit.

Das Volumen des in dem Tiegel 6 zunächst befindlichen Siliziumgranulats, das erhebliche Hohlräume enthält, ist durch den Aufschmelzprozess auf etwa die Hälfte bis zwei Drittel geschrumpft, so dass der Tiegel 6 nur teilweise gefüllt ist, was zu einer entsprechend geringeren Produktivität der Anlage führt. Durch Anheben der Stopfenstange und Nachchargieren der vorgewärmten, getrockneten und/oder entgasten und sehr rieselfähigen Charge wird das verfügbare Restvolumen des Tiegels 6 aufgefüllt, wodurch die Produktivität entsprechend erhöht und bis nahezu verdoppelt wird. Außerdem wird das ansonsten erfolgende Spritzen der Schmelze durch Gasfreisetzung aus der neuen Charge in der Schmelze verhindert.

Für die Heizeinrichtungen 8, 13 und 14 werden handelsübliche Materialien verwendet, beispielsweise Graphit, ggf. verstärkt durch Kohlefasern wie sog. CFC-Material (Kohlenstoff-Fasern-Kohlenstoff). Für die Umfangsheizeinrichtung 8 kann auch eine Induktionsspule verwendet werden, da der aus Graphit bestehende Behälter 7 des Tiegels 6 als Suszeptor für elektromagnetische Wellen wirkt. Für die Teile der Wärmedämmeinrichtung 9 kann beispielsweise Fasermaterial wie Graphitfilz verwendet werden oder auch Graphitfolien.

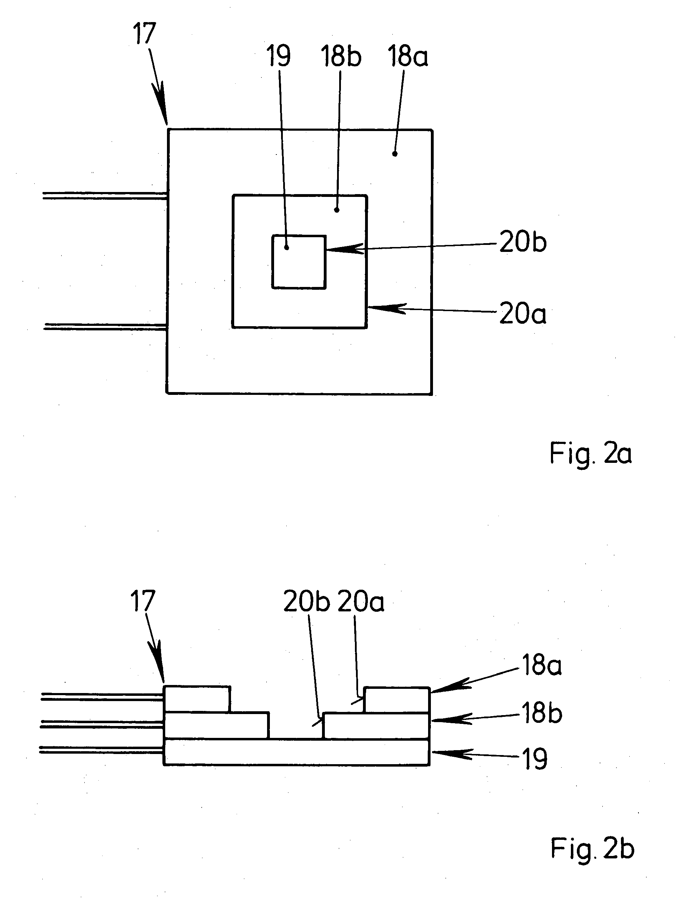

Die Fig. 2a, b zeigt eine Ausführung der Strahlungssperre 17 mit drei Isolationsplatten 18a, 18b, 19, die einen Stapel bilden. Die Außenabmessung der Isolationsplatten 18a, 18b, 19 sind gleich, so dass sie übereinander angeordnet zur Deckung gebracht werden können.

Bis auf die untere Isolationsplatte 19, die vollflächig ausgeführt ist, besitzen die Isolationsplatten 18a, 18b jeweils eine Ausnehmung 20a, 20b, deren Abmessungen von oben nach unten immer kleiner werden. Die oberste Isolationsplatte 18a hat somit die größte Ausnehmung 20a.

Die Abmessungen der Ausnehmungen 20a, 20b sind zueinander und zur Außenabmessung des Stapels ausgeführt, das heißt, dass ihre Diagonalen übereinanderliegen: Durch die Verwendung von drei oder auch mehr Isolationsplatten kann die Strahlungssperrwirkung so eingestellt werden, dass sie vom Rand des Tiegelbodens zu dessen Zentrum hin in mehreren Schritten stufenweise abnimmt.

### Bezugszeichenliste

- 1: Kristallisationskammer
- 5: Kristallisationseinrichtung
- 6: Tiegel
- 6a: Tiegelöffnung
- 6b: Tiegelboden
- 8: Umfangsheizeinrichtung
- 9: Wärmedämmeinrichtung
- 10: Boden
- 11: Seitenwände
- 12: Deckel
- 13: Deckenheizeinrichtung
- 14: Bodenheizeinrichtung
- 15: Siliziumschmelze
- 16: Hohlraum
- 17: Strahlungssperre
- 18a: Isolationsplatte mit Ausnehmung
- 18b: Isolationsplatte mit Ausnehmung
- 19: volle Isolationsplatte
- 20a: Ausnehmung
- 20b: Ausnehmung
- 21: Kühlplatte

## Patentansprüche

1. Vorrichtung zum gerichteten Erstarren geschmolzener Metalle, aufweisend einen Tiegel (6), eine Heizeinrichtung (8, 13, 14)) und eine Kühlplatte unterhalb des Tiegelbodens, **dadurch gekennzeichnet,**
**dass** eine entfernbare Strahlungssperre (17) zwischen dem Tiegelboden (6b) und der Kühlplatte angeordnet ist,
**dass** die Strahlungssperre (17) aus wenigstens zwei übereinander angeordneten Isolationsplatten (18a, 18b, 19) besteht, die einen Stapel bilden und die unabhängig voneinander entfernbar sind,
und **dass** wenigstens eine der Isolationsplatten (18a, 18b, 19) des Stapels wenigstens eine zentrale Ausnehmung (20a, 20b) aufweist.

2. Vorrichtung nach Anspruch 1, **dadurch gekennzeichnet, dass** die Strahlungssperre (17) aus wenigstens drei übereinander angeordneten Isolationsplatten (18a, 18b, 19) besteht.

3. Vorrichtung nach Anspruch 2 oder 3, **dadurch gekennzeichnet, dass** die oberste Isolationsplatte (18a) des Stapels wenigstens eine Ausnehmung (20a) aufweist.

4. Vorrichtung nach Anspruch 3, **dadurch gekennzeichnet, dass** die Ausnehmung (20a) der obersten Isolationsplatte (18a) zentral angeordnet ist.

5. Vorrichtung nach Anspruch 4, **dadurch gekennzeichnet, dass** eine unterhalb der obersten Isolationsplatte (18a) liegende Isolationsplatte (18b) ebenfalls eine Ausnehmung (20b) aufweist.

6. Vorrichtung nach Anspruch 5, **dadurch gekennzeichnet, dass** die Öffnungsflächen der Ausnehmungen (20a, 20b) von weiter oben liegenden Isolationsplatten (18b) sukzessive größer werden, je höher sie im Stapel liegen,

7. Vorrichtung nach Anspruch 6, **dadurch gekennzeichnet, dass** die Ausnehmungen (20a, 20b) der Isolationsplatten eine gemeinsame Symmetrieachse aufweisen.

8. Vorrichtung nach einem der vorhergehenden Ansprüche, **dadurch gekennzeichnet, dass** die Heizeinrichtung wenigstens eine Bodenheizeinrichtung (14) unterhalb des Bodens (6b) des Tiegels (6) aufweist, und dass die Strahlungssperre (17) unterhalb der Bodenheizeinrichtung (14) angeordnet ist.

9. Vorrichtung nach einem der vorhergehenden Ansprüche, **dadurch gekennzeichnet, dass** die Isolationsplatten (18a, 18b, 19) aus Graphit, Graphitfilz, Keramik oder aus einer Materialkombination der genannten Materialien bestehen.

10. Vorrichtung nach einem der vorhergehenden Ansprüche, **dadurch gekennzeichnet, dass** die Isolationsplatten (18a, 18b, 19) unterschiedlich dick sind.

## Claims

1. A device for the directed solidification of molten metals, comprising a crucible (6), a heating device (8, 13, 14) and a cooling plate beneath the crucible base, **characterised in that**
a removable radiation barrier (17) is disposed between the crucible base (6b) and the cooling plate,
the radiation barrier (17) comprises at least two insulation plates (18a, 18b, 19) which are disposed one above the other and which form a stack and which are removable independently of one another,
and at least one of the insulation plates (18a, 18b, 19) of the stack comprises at least one central recess (20a, 20b).

2. The device according to claim 1, **characterised in that** the radiation barrier (17) comprises at least three insulation plates (18a, 18b, 19) disposed above one another.

3. The device according to claim 2 or 3, **characterised in that** the uppermost insulation plate (18a) of the stack comprises at least one recess (20a).

4. The device according to claim 3, **characterised in that** the recess (20a) of the uppermost insulation plate (18a) is disposed centrally.

5. The device according to claim 4, **characterised in that** an insulation plate (18b) lying beneath the uppermost insulation plate (18a) also comprises a recess (20b).

6. The device according to claim 5, **characterised in that** the opening areas of the recesses (20a, 20b) of insulation plates (18b) lying farther up become successively larger the higher they are in the stack.

7. The device according to claim 6, **characterised in that** the recesses (20a, 20b) of the insulation plates have a common axis of symmetry.

8. The device according to any one of the preceding claims, **characterised in that** the heating device comprises at least one base heating device (14) beneath the base (6b) of the crucible (6), and that the radiation barrier (17) is disposed beneath the base heating device (14).

9. The device according to any one of the preceding claims, **characterised in that** the insulation plates (18a, 18b, 19) are made of graphite, graphite felt, ceramic or a material combination of the stated materials.

10. The device according to any one of the preceding claims, **characterised in that** the insulation plates (18a, 18b, 19) are of different thicknesses.

## Revendications

1. Dispositif de solidification dirigée de métal fondu comportant un creuset (6), un système de chauffage (8, 13, 14) et une plaque de refroidissement en dessous du fond de creuset, **caractérisé**
**en ce qu'**un blocage de rayonnement (17) démontable est disposé entre le fond de creuset (6b) et la plaque de refroidissement,
**en ce que** le blocage de rayonnement (17) est composé d'au moins deux plaques d'isolation (18a, 18b, 19) disposées l'une sur l'autre qui forment une pile et qui peuvent être démontées indépendamment l'une de l'autre, et
**en ce qu'**au moins une des plaques d'isolation (18a, 18b, 19) de la pile comporte au moins un évidement (20a, 20b) central.

2. Dispositif selon la revendication 1, **caractérisé en ce que** le blocage de rayonnement (17) est composé d'au moins trois plaques d'isolation (18a, 18b, 19) disposées l'une sur l'autre.

3. Dispositif selon la revendication 2 ou 3, **caractérisé en ce que** la plaque d'isolation supérieure (18a) de la pile comporte au moins un évidement (20a).

4. Dispositif selon la revendication 3, **caractérisé en ce que** l'évidement (20a) de la plaque d'isolation supérieure (18a) est disposé de façon centrale.

5. Dispositif selon la revendication 4, **caractérisé en ce qu'**une plaque d'isolation (18b) située en dessous de la plaque d'isolation supérieure (18a) comporte également un évidement (20b).

6. Dispositif selon la revendication 5, **caractérisé en ce que** les surfaces d'ouverture des évidements (20a, 20b) deviennent, plus elles se trouvent hautes dans la pile, successivement plus grandes que les plaques d'isolation (18b) situées bien au-dessus.

7. Dispositif selon la revendication 6, **caractérisé en ce que** les évidements (20a, 20b) des plaques d'isolation comportent un axe de symétrie commun.

8. Dispositif selon une quelconque des revendications précédentes, **caractérisé en ce que** le système de chauffage comporte au moins un système de chauffage de fond (14) en dessous du fond (6b) du creuset (6) et **en ce que** le blocage de rayonnement (17) est disposé en dessous du système de chauffage de fond (14).

9. Dispositif selon une quelconque des revendications précédentes, **caractérisé en ce que** les plaques d'isolation (18a, 18b, 19) sont en graphite, feutre de graphite, céramique ou en une combinaison de matériaux des matériaux cités.

10. Dispositif selon une quelconque des revendications précédentes, **caractérisé en ce que** les plaques d'isolation (18a, 18b, 19) sont différentes en épaisseur.
